# DEMANDE DE BREVET EUROPEEN

(11) **EP 0 574 076 A1**
(43) Date de publication de la demande: **15.12.1993**
(21) Numéro de dépôt: 93201577.9
(22) Date de dépôt: 02.06.1993
(51) Int. Cl.: G01R 1/06, G01R 1/24, H04B 3/04

(54) **Sonde pour prélever des signaux électriques**

(30) Priorité: 10.06.1992 FR 9206986
(71) Demandeur: LABORATOIRES D'ELECTRONIQUE PHILIPS, 94450 Limeil-Brévannes (FR); Philips Electronics N.V., 5621 BA Eindhoven (NL)
(72) Inventeur: Raoulx, Denis, Société Civile S.P.I.D., F-75008 Paris (FR)
(74) Mandataire: Landousy, Christian

(57) **Abrégé**

Sonde (12) pour prélever des signaux électriques comprenant un câble (11) ayant au moins une ligne de transmission entre une borne d'entrée (E) et une borne de sortie (S), la ligne de transmission comprenant un fil porteur desdits signaux électriques et une ligne de référence. Elle est remarquable en ce que le fil porteur est formé de tronçons (111a, 111b), deux tronçons consécutifs étant reliés entre eux par au moins une résistance R_{M} placée en série.

Pour affiner la constance de la réponse en fréquence, il est possible de placer une résistance en entrée (R_{E}) et/ou en sortie (R_{S}) de la ligne de transmission.

La sonde peut comprendre plusieurs voies, chaque voie ayant la sortie (S) de sa ligne de transmission connectée à un comparateur (40) muni de capacités programmables pour adapter les impédances entrée/sortie de chaque voie.

## Description

L'invention concerne une sonde pour prélever des signaux électriques comprenant un câble ayant au moins une ligne de transmission entre une borne d'entrée et une borne de sortie, la ligne de transmission comprenant un fil porteur desdits signaux électriques et une ligne de référence.

Une telle sonde peut être utilisée pour faire parvenir un signal électrique sur différents appareillages de mesure et/ou de test tels que des analyseurs logiques, des oscilloscopes, des analyseurs de spectres ou tout autre appareillage sur lequel un signal à analyser doit parvenir.

Selon une conception classique et simplifiée, la sonde peut être formée d'un simple câble muni en tête d'une pointe destinée à être mise en contact avec le signal à prélever. Il n'y a alors pas de circuits actifs dans la tête de sonde.

Pour prélever les signaux à analyser, on place alors un amplificateur (oscilloscope) ou un comparateur (analyseur logique) dans l'appareil de mesure. Mais il est difficile de transmettre des signaux HF sur des câbles ayant des longueurs de 1 mètre et plus surtout avec de fortes impédances d'entrée de sonde. Une telle solution ne peut convenir que pour des signaux à relativement basses fréquences. Lorsque les fréquences des signaux à transmettre atteignent le domaine des hautes fréquences, pour des câbles de longueur élevée, (supérieures à 200 MHz environ, sur un câble de 1-2 mètres), il est nécessaire d'utiliser par exemple des sondes actives qui permettent de prélever le signal avec une perturbation minimale du signal mesuré.

Ainsi, on connaît des sondes avec une tête active pour prélever des signaux ayant des fréquences à transmettre atteignant 1 à 2 GHz. Dans la tête, on place des comparateurs à haute résistance d'entrée et à faible capacité d'entrée, destinés à discriminer des niveaux d'amplitude du signal. Ceci permet d'attaquer le câble sous une faible impédance, nécessitée par les lignes de transmissions tels que par exemple les câbles coaxiaux. De plus, le placement des comparateurs dans la tête de sonde permet à la sonde de disposer d'une impédance d'entrée élevée associée à une faible capacité d'entrée. Néanmoins, l'architecture de telles sondes actives est assez complexe. Elles sont de ce fait très onéreuses. De plus, ces sondes nécessitent généralement de nombreux fils de connexion par signal entre la tête de sonde et l'appareil de mesure. Il faut placer dans la tête de sonde un circuit intégré actif qui est onéreux et accroît assez fortement le volume et le poids de la tête de sonde.

Une autre possibilité consiste à placer la partie active non pas dans la tête de sonde mais dans un circuit satellite placé à une certaine distance de la tête, de sorte que le câble soit formé de deux parties. Certains problèmes propres aux solutions précédentes sont moins perturbateurs. Ainsi, avec une portion de câble court (ligne de transmission) entre la tête et le circuit satellite, on améliore la réponse en fréquence de la sonde. Egalement le poids et le volume de la tête de sonde sont réduits ce qui facilite grandement l'utilisation du matériel.

Pour conserver le mieux possible l'intégrité du signal entre son point de prélèvement et les comparateurs, on a utilisé des câbles ayant des fils porteurs résistifs. Pour ce type d'usage, le document US 4.777.326 décrit un câble plat tissé dans lequel les connexions de transmission sont constituées de fils résistants. Mais ces câbles à pertes continûment réparties présentent plusieurs inconvénients. En particulier, il est difficile de réaliser des câbles résistifs ayant une résistance nominale suffisante pour la transmission de signaux avec une fréquence de l'ordre du GHz sur une distance de 20 cm. D'autre part, cette structure est sensible aux capacités d'entrée du comparateur et une procédure assez délicate à réaliser d'ajustement de capacité est nécessaire pour obtenir les meilleures performances.

Le but de l'invention est de définir le meilleur compromis possible entre :
- des impératifs techniques liés à la bande passante de la sonde,
- des impératifs de poids et de volume réduits pour une utilisation aisée de la tête de sonde,
- des impératifs de coût faible pour la sonde.

Ce but est atteint à l'aide d'une sonde, du genre décrit dans le premier paragraphe, ayant un fil porteur formé de tronçons, deux tronçons consécutifs étant reliés entre-eux par au moins une résistance R_{M} placée en série.

Ainsi avantageusement, on conserve l'intégrité des signaux électriques à prélever sur une gamme de fréquences étendue allant du continu à au-delà de 1 GHz. En ne mettant aucun composant actif dans la tête de sonde celle-ci est alors très légère et peu volumineuse. De plus, il n'est pas nécessaire de fabriquer des câbles résistifs spéciaux qui peuvent devenir onéreux. Seuls des câbles de transmission classiques et des résistances discrètes classiques sont mis en oeuvre.

On peut adjoindre une résistance R_{E} placée en série entre un tronçon d'un fil porteur et la borne d'entrée.

On peut aussi adjoindre une résistance R_{S} placée en série entre un tronçon du fil porteur et la borne de sortie. L'adjonction des résistances R_{E} et/ou R_{S} permet d'améliorer la transmission des signaux et d'avoir une réponse en fréquence la plus plate possible.

Le câble sert à transmettre des signaux à prélever vers un circuit satellite qui possède une haute impédance d'entrée et une faible impédance de sortie. Préférentiellement, le circuit satellite est un circuit actif comprenant au moins un comparateur.

Il est possible d'adapter l'impédance d'entrée et/ou l'impédance de sortie du câble à l'aide de capacités d'accord pour affiner la bande passante de la sonde.

Pour disposer de plusieurs voies, on peut soit utiliser plusieurs câbles soit utiliser un câble comprenant plusieurs fils porteurs. Il est possible d'adapter l'impédance de sortie de chaque fil porteur à l'impédance d'entrée du comparateur de voie en disposant un circuit à capacités programmables en sortie du/des fils porteurs. Ceci permet de réduire les dispersions à la fois en gain et en bande passante entre les voies.

La ligne de transmission peut être une ligne microruban déposée sur un substrat, un plan masse constituant la ligne de référence. Elle peut aussi être un câble coaxial ou une ligne bifilaire.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :
Figure 1-A : une sonde connue connectée directement à un appareillage de mesure.
Figure 1-B : une sonde connue connectée à un appareillage de mesure à travers un circuit satellite.
Figure 2 : un schéma connu pour l'adaptaton des impédances en entrée et en sortie d'un câble coaxial.
Figure 3 : une structure de base de réalisation de l'invention avec une résistance R_{M} placée entre deux tronçons d'un fil porteur.
Figure 4 : une première (4-A) adjonction d'une résistance R_{E} en entrée d'un fil porteur et une seconde (4-B) adjonction d'une résistance R_{S} en sortie d'un fil porteur.
Figure 5 : un schéma d'une partie de sonde avec un circuit satellite muni d'un circuit à capacités programmables en entrée du comparateur.
Figure 6 : un schéma d'un exemple de réalisation d'un circuit à capacités programmables.
Figure 7 : plusieurs modes (A-G) d'adjonction d'éléments d'accord en entrée ou en sortie d'un fil porteur ou aux extrémités de la résistance R_{M} pour affiner la bande passante.

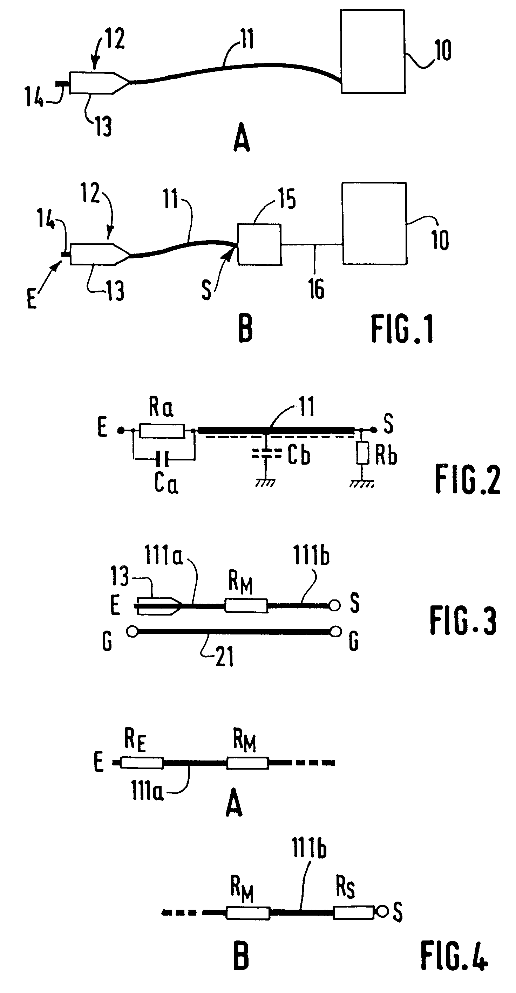

Pour une meilleure compréhension de l'invention, l'état de l'art est d'abord exposé (figures 1-A, 1-B).

La figure 1-A représente un exemple connu pour prélever des signaux électriques à l'aide d'un appareillage de mesure 10 relié à une sonde 12. Celle-ci comprend un câble 11 qui relie une tête 13 à l'appareillage 10. La tête comprend une pointe de sonde 14 qui sert à prélever un signal à mesurer en plaçant la pointe 14 en contact avec un organe à tester (non représenté). Pour que l'utilisateur dispose d'une facilité de travail, le câble 11 présente une certaine longueur qui peut aller de quelques centimères à 1 mètre et même plus.

Selon que les signaux à tester sont à fréquences basses ou à fréquences élevées, la constitution de la sonde 12 en dépend. Généralement, on demande à la sonde de pouvoir transmettre aussi bien des signaux à hautes fréquences que des signaux à basses fréquences voire des niveaux continus. C'est bien sûr la transmission des signaux HF entre la pointe 14 et l'appareillage 10 qui pose les problèmes les plus délicats. Néanmoins, une sonde qui apporte une solution à ces problèmes doit généralement pouvoir satisfaire aussi aux nécessités de la transmission des basses fréquences et du niveau continu.

Pour résoudre ce problème de transmission, il existe des sondes pour lesquelles la tête 13 comprend des moyens pour prélever les signaux sur la pointe avec une faible perturbation et les amplifier pour les transmettre sur le câble avec la faible impédance de sortie nécessaire à la transmission de signaux rapides. Une telle tête 13 est alors munie de moyens de conversion comprenant des composants actifs qui sont généralement onéreux dans ces gammes de fréquences HF concernées. Leur consommation en énergie électrique est généralement jugée élevée. De plus, il faut adjoindre au câble 11 des moyens en alimentation électrique ce qui diminue la flexibilité du câble, et, s'ajoutant à la complexité de la sonde 13, rend celle-ci encombrante et lourde pour l'usage prévu.

Une solution de compromis consiste à réduire la longueur du câble 11 pour que les problèmes de transmission ne soient pas trop cruciaux, à réduire la complexité de la tête 13 à une simple batterie de touches de contact 14 et à effectuer le traitement du signal dans un circuit satellite 15 (figure 1-B). Les signaux à analyser sont convertis par le circuit 15 en signaux dont la transmission (connexion 16) entre le circuit 15 et le dispositif 10 ne pose alors plus de difficultés. Le câble 11 peut être formé d'une nappe de fils de connexion ou de plusieurs câbles coaxiaux.

Pour obtenir une grande impédance d'entrée, il est courant d'adjoindre au câble coaxial deux résistances et une capacité comme cela est représenté sur la figure 2. On dispose en entrée une capacité série Ca de faible valeur en parallèle sur une résistance série Ra de valeur assez élevée et en sortie on dispose une résistance Rb en parallèle entre S et la ligne de référence. Pour obtenir un gain uniforme aussi bien en continu qu'en haute fréquence, en appelant Cb la capacité répartie du câble coaxial, il faut avoir sensiblement Ra.Ca = Rb.Cb en ne tenant pas compte des autres éléments parasites.

On reste néanmoins limité pour la transmission des signaux HF du côté des fréquences élevées tout au long du câble 11. Préférentiellement, l'invention conserve une même combinaison que celle de la figure 1-B mais apporte des solutions pour la transmission entre la pointe de touche 14 (ou à proximité de la pointe de touche 14) formant l'entrée de la sonde et repérée par la suite par la lettre E, et l'entrée du circuit satellite 15 formant la sortie de la ligne de transmission HF et repérée par la suite par la lettre S.

La figure 3 représente un mode fondamental de réalisation d'une partie de la sonde selon l'invention en ignorant pour l'instant les adaptations d'impédance en entrée et en sortie. Entre la borne d'entrée E et la borne de sortie S, le câble 11 comprend au moins un fil porteur qui est divisé en deux tronçons 111a et 111b qui sont reliés par une résistance R_{M}. Le signal à analyser est appliqué entre l'entrée du tronçon 111a, et une borne G d'un fil 21 de référence (masse).

La tête de sonde 13 représentée sur la figure 3 constitue dans ce cas un organe de manipulation et de protection. L'extrémité du tronçon 111a constitue la touche de contact 14 à l'extrémité E.

Du fait de l'existence d'une résistance R_{M} disposée le long du fil porteur ceci constitue une approximation d'une ligne de transmission avec pertes. Cette réalisation est particulièrement avantageuse par sa simplicité, par son coût de réalisation et son aptitude à pouvoir permettre d'obtenir des courbes de réponses plates avec la fréquence dans un domaine de fréquences étendu atteignant 2 GHz. La reproductibilité des caractéristiques d'une telle ligne est mieux assurée qu'avec une ligne de transmission à pertes uniformément réparties beaucoup plus délicate à mettre en oeuvre.

La détermination des caractéristiques de la ligne de transmission avec pertes selon l'invention s'opère en optimisant des paramètres selon les deux critères suivants :
- on peut chercher à obtenir une réponse la plus constante possible sur une bande de fréquences donnée,
- on peut également chercher à obtenir une réponse ayant un taux prédéterminé d' ondulation maximale sur une bande de fréquence la plus étendue possible.

Ces deux approches peuvent être combinées.

L'optimisation des paramètres est effectuée par une technique de simulation de lignes de transmission connue de l'homme du métier. Les paramètres tels que les longueurs des tronçons 111a, 111b, la valeur de la résistance R_{M} sont ajustés pour que, un signal étant appliqué entre les bornes E, G, une onde se propage le long de la ligne de transmission et donne naissance entre les bornes S, G à un signal ayant les caractéristiques souhaitées sur la bande de fréquences prédéterminée. Une telle simulation est effectuée en incluant tous les éléments compris entre la tête de sonde et le comparateur. En particulier, toutes les capacités parasites peuvent être prises en compte ainsi que les inductances des boîtiers et des connecteurs éventuels. Tous les paramètres de la ligne de transmission intervenant dans le cadre d'une exploitation réelle peuvent ainsi être considérés : longueur totale du câble 11, impédance caractéristique de la ligne, capacité d'entrée. On peut ainsi obtenir une meilleure optimisation donc de meilleures performances comparées à un câble à pertes uniformément réparties. Le résultat d'une telle simulation est la détermination de la valeur de la résistance R_{M} ainsi que les longueurs des tronçons 111a et 111b à utiliser pour obtenir les performances souhaitées. L'optimisation de la ligne consiste ainsi à éviter les réflexions de l'onde dans la ligne lorsque les temps de montée du signal sont inférieurs aux durées de propagation dans la ligne.

Pour effectuer une simulation de telles lignes de transmission, l'homme du métier peut par exemple opérer de la manière suivante. On considère une ligne de transmission ayant une impédance caractéristique et une vitesse de propagation d'ondes données. A l'entrée de cette ligne, on applique une tension alternative V et on mesure en sortie une tension alternative v. En utilisant les équations décrivant la propagation d'ondes dans une ligne de transmission sans perte, on peut simuler la ligne de transmission de l'invention comme étant formée de deux tronçons de ligne sans perte réunis entre eux par une résistance série R_{M}, le tronçon de ligne placé en sortie étant chargé par l'impédance d'entrée du circuit prévu pour être connecté en sortie dudit tronçon.

Par essais successifs effectués par simulation sur les valeurs de R_{M} et sur les longueurs respectives de chacun des deux tronçons de ligne sans perte, on détermine des valeurs pour R_{M} et pour lesdites longueurs qui satisfont aux critères cités.

On peut aisément étendre cette méthode au calcul d'une ligne selon l'invention formée de plusieurs résistances reliant plusieurs tronçons de ligne sans perte.

En effet, en ne mettant en oeuvre qu'une seule résistance R_{M} placée entre deux tronçons 111a, 111b, pour certaines situations, les degrés de réglage peuvent être limités. En introduisant d'autres paramètres de réglage, on peut ainsi accroître les performances. Ainsi, il est possible de disposer par exemple une résistance R_{E} à l'entrée du tronçon 111a (figure 4-A) ou une résistance R_{S} à la sortie du tronçon 111b (figure 4-B). On peut également combiner l'action des deux résistances R_{E} et R_{S}. On peut également répartir le câble 11 en un plus grand nombre de tronçons et utiliser plusieurs résistances de jonction. Ceci permet d'affiner la réponse en fréquences de la sonde.

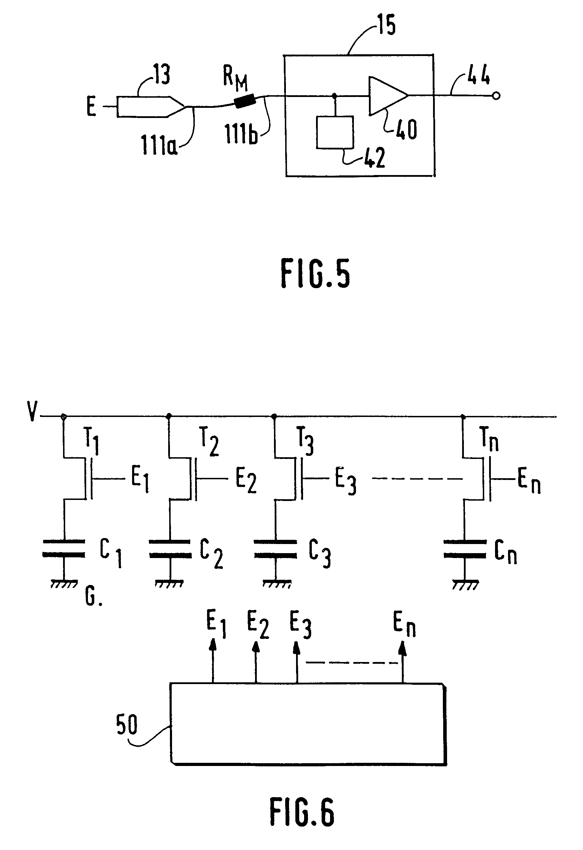

La ligne de transmission ainsi déterminée est réunie à un comparateur 40 placé dans le circuit satellite 15. Sur la figure 5 sont représentés un circuit satellite 15 et une ligne de transmission 111a, 111b, R_{M} représentée simplement par le fil porteur, le fil de référence étant omis par simplification. Une sonde comprend généralement plusieurs voies donc plusieurs fils porteurs, correspondant chacun au schéma de la figure 5. Tous les comparateurs 40 peuvent être réunis dans un même circuit intégré.

Les comparateurs ne possèdent pas tous des caractéristiques d'entrée identiques et il apparaît généralement des dispersions en particulier sur les capacités d'entrée ou les selfs de connexion (broches d'entrée). Il est possible de corriger une voie indépendamment d'une autre voie en plaçant à l'entrée du comparateur de voie un circuit 42 à capacités programmables (figure 5). En compensant ainsi les dispersions entre les voies, il est possible d'obtenir que chaque voie puisse être déterminée pour avoir une réponse en fréquence conforme aux caractéristiques souhaitées. La figure 6 indique un exemple de circuit 42 à capacités programmables. Entre une ligne d'alimentation V et une référence G (masse), on dispose en parallèle une batterie de capacités C₁, C₂... Cₙ, chacune en série avec un transistor MOS T₁, T₂... Tₙ dont les grilles sont commandées par des signaux E₁, E₂... Eₙ. Ces capacités C₁, C₂... Cₙ ont des valeurs différentes permettant de disposer d'une gamme de valeurs, par exemple, C₁ = 1 pF, C₂ = 0,5 pF, C₃ = 0,25 pF et ainsi de suite. Lors du réglage de la sonde, on active les signaux E₁, E₂... Eₙ appropriés pour mettre en oeuvre les capacités C₁, C₂... Cn appropriées à une réponse optimale de la voie. Il est possible de supprimer l'existence physique des capacités C₁, C₂... Cₙ en utilisant les capacités de drain ou de source des transistors MOS. Lors du réglage, on teste le signal en sortie 44 du comparateur de voie 40 (figure 5) et la sélection des capacités est faite en conséquence. Une unité de commande 50 est ainsi programmée pour activer certains signaux parmi les signaux E₁, E₂... Eₙ. Cette unité de commande 50 fait partie du circuit 42 à capacités programmables.

Toujours pour affiner la réponse en fréquence de chaque voie, il est possible d'adjoindre des éléments de correction (en particulier des capacités) en différents endroits de chaque voie entre un point de la ligne de transmission et la masse G.

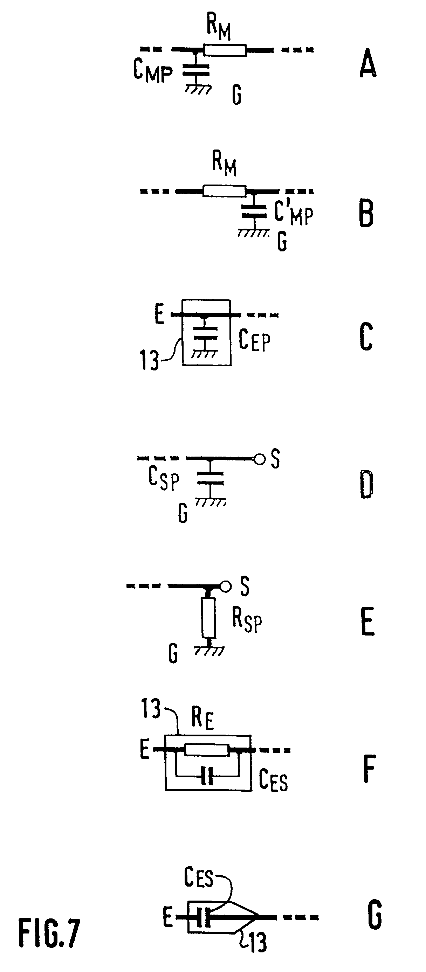

Ainsi ce point peut être :
- une extrémité de la résistance R_{M} : capacité C_{MP} (figure 7A),
- l'autre extrémité de la résistance R_{M} : capacité C'_{MP} (figure 7B),
- l'entrée E du fil porteur : capacité C_{EP} (figure 7C),
- la sortie S du fil porteur : capacité C_{SP} (figure 7D),
- la sortie S du fil porteur : résistance R_{SP} (figure 7E).

Des éléments de corrections peuvent aussi être placés en parallèle sur la résistance R_{E} : par exemple capacité C_{ES} (figure 7F). Pour supprimer un niveau continu, on peut également placer une capacité C_{ES} sur la borne d'entrée E en série avec le fil porteur (figure 7G).

En ajoutant ces éléments de corrections, on obtient des modes particuliers de réalisation destinés à améliorer la réponse en fréquence de la sonde. Il peut être en outre nécessaire d'adapter les impédances en entrée et en sortie comme cela est indiqué sur la figure 2. L'homme du métier peut compléter ces exemples selon les techniques connues.

Selon un exemple préférentiel de réalisation, une sonde ayant une réponse en fréquence plate à mieux que 10 % jusqu'à une fréquence de 1 GHz avait les paramètres suivants : R_{E} = 220 ohms, R_{M} = 120 ohms, R_{S} = 110 ohms, Rₐ = 42 K.ohms, Ca = 2,4 pF, Rb = 8,3 K.ohms, la longueur du tronçon 111a étant de 8,6 cm et la longueur du tronçon 111b étant de 11,4 cm.

Ces valeurs ont été déterminées pour un câble ayant une impédance caractéristique de 95 ohms et une constante diélectrique de 2,1.

## Revendications

1. Sonde (12) pour prélever des signaux électriques comprenant un câble (11) ayant au moins une ligne de transmission entre une borne d'entrée (E) et une borne de sortie (S), la ligne de transmission comprenant un fil porteur desdits signaux électriques et une ligne de référence, caractérisée en ce que le fil porteur est formé de tronçons (111a, 111b), deux tronçons consécutifs étant reliés entre-eux par au moins une résistance R_{M} placée en série.

2. Sonde selon 1a revendication 1 caractérisée en ce qu'une résistance R_{E} est placée en série entre un tronçon (111a) d'un fil porteur et la borne d'entrée (E).

3. Sonde selon une des revendications 1 ou 2 caractérisée en ce qu'une résistance R_{S} est placée en série entre un tronçon (111b) du fil porteur et la borne de sortie (S).

4. Sonde selon une des revendications 1 à 3 caractérisée en ce que au moins une résistance (R_{M}, R_{E}, R_{S}), connectée à un tronçon du fil porteur, est connectée à un élément d'accord (C_{MP}, C'_{MP}, C_{EP}, C_{SP}, C_{ES}, R_{SP}) pour améliorer la bande passante de la sonde.

5. Sonde selon une des revendications 1 à 4 caractérisée en ce que la ligne de transmission est soit une ligne microruban soit une ligne coaxiale soit une ligne bifilaire.

6. Sonde selon une des revendications 1 à 5 caractérisée en ce qu'elle est munie d'éléments (R, C) pour adapter les impédances d'entrée et/ou de sortie du câble.

7. Sonde selon une des revendications 1 à 6 caractérisée en ce que la borne de sortie (S) d'un tronçon (111b) de fil porteur est connectée à un comparateur (40) placé dans un circuit satellite (15).

8. Sonde selon la revendication 7 caractérisée en ce que le circuit satellite (15) comprend un circuit (42) à capacités programmables pour adapter l' impédance de sortie du fil porteur à l'impédance d'entrée du comparateur.

9. Sonde selon la revendication 8 caractérisée en ce que les capacités programmables sont formées de transistors MOS.
